# EUROPEAN PATENT APPLICATION

(11) **EP 3 840 229 A1**
(43) Date of publication of application: **23.06.2021**
(21) Application number: 19216391.3
(22) Date of filing: 16.12.2019
(51) Int. Cl.: H03M 3/00

(54) **RADIO FREQUENCY RECEIVER SYSTEM**

(71) Applicant: Koninklijke Philips N.V., 5656 AG Eindhoven (NL)
(72) Inventor: POL, Ketan Jayant, 5656 AE Eindhoven (NL); OUZOUNOV, Sotir Filipov, 5656 AE Eindhoven (NL); VAN LIERE, Filips, 5656 AE Eindhoven (NL); TOTEV, Emil Dimitrov, 5656 AE Eindhoven (NL); SHRESTHA, Rameswor, 5656 AE Eindhoven (NL)
(74) Representative: Philips Intellectual Property & Standards

(57) **Abstract**

For a radio frequency (RF) receiver system (1) for providing magnetic resonance (MR) information from an examination space of a MR imaging system, a solution for lowering the average power consumption and the overall noise of the radio frequency (RF) receiver system (1) for a better imaging performance shall be created. This is achieved by a radio frequency (RF) receiver system (1) comprising a RF band-pass sigma-delta analog to digital converter (ADC) (6), the RF band-pass sigma-delta ADC comprising a quantizer unit (9), and a feedback digital to analog converter (DAC) unit (10), the quantizer unit (9) and the feedback DAC unit (10) are provided as N bit converter units with N being an integer greater than 1, wherein the feedback DAC unit (10) is a non-uniform feedback DAC unit, wherein the quantizer unit (9) is a non-uniform quantizer unit, the non-uniform feedback DAC unit (10) being arranged to produce analog levels in response to the levels produced by the non-uniform quantizer unit (9), the ADC (6) being arranged to produce non-uniform quantization levels by the non-uniform quantizer unit (9) and the feedback DAC unit (10) in proportion to the applied ADC input signal. The present invention also refers to a magnetic resonance (MR) imaging system, a method for providing magnetic resonance (MR) information from an examination space of a magnetic resonance (MR) imaging system, a software package for a magnetic resonance (MR) imaging system and a software package for upgrading a magnetic resonance (MR) imaging system.

## Description

### FIELD OF THE INVENTION

The invention relates to the field of magnetic resonance (MR) imaging. In particular, the invention relates to a radio frequency (RF) receiver system for providing magnetic resonance (MR) information from an examination space of a MR imaging system. The invention further relates to a magnetic resonance (MR) imaging system, a method for providing magnetic resonance (MR) information from an examination space of a magnetic resonance (MR) imaging system, a software package for a magnetic resonance (MR) imaging system and a software package for upgrading a magnetic resonance (MR) imaging system.

### BACKGROUND OF THE INVENTION

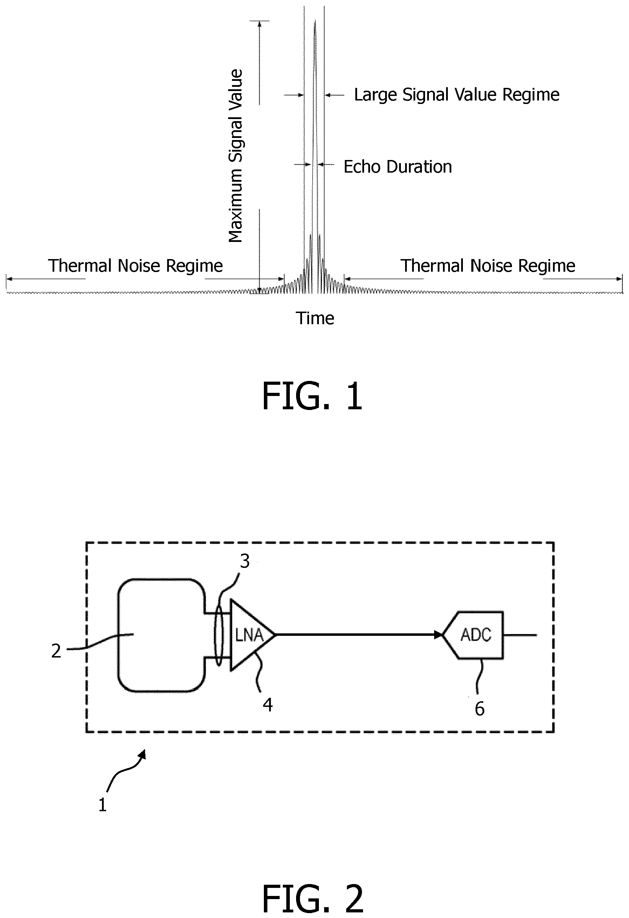

Analog signals received during MR-imaging exhibit a very large dynamic range. The received signal is very small for the majority of the acquisition period and is very large for a very tiny interval. Fig. 1 depicts an example illustrating the signal behavior showing the amplitude statistics in time. Currently, the front-end reception system needs to maintain a large dynamic range for the complete acquisition period. This means that the system has to support with high performance simultaneously low signals levels i.e. to have excellent noise performance and high signal levels that require excellent linearity but are far less sensitive to the noise levels. An implementation that satisfies the requirements for both low and high signal levels is wasteful in terms of power and much more complex to be reliably implemented. If the system can be made autonomously adapt to instantaneous signal levels, it can be optimized significantly, i.e. the power consumption can be tied to the instantaneous signal amplitude and the resulting system would be very efficient.

The dynamic range of the received MR signal is too large to be acquired efficiently with a fixed ADC topology. Many existing front-end solutions employ either a variable gain amplifier or multiple ADCs that are enabled step-wise to acquire different amplitude levels. These solutions are inefficient in terms of both power and silicon and/or PCB area.

In WO 2014/166983 a radio frequency (RF) antenna device for providing magnetic resonance (MR) information from an examination space of a MR imaging system is disclosed, comprising at least one RF coil with at least one connection port for receiving an analog MR information signal, and at least one analog to digital converter (ADC), which is connected to the at least one connection port and which converts the analog MR information signal into a digital MR information signal, whereby the at least one ADC is a RF band-pass sub-sampled sigma-delta analog to digital converter.

### SUMMARY OF THE INVENTION

It is an object of the invention to provide a radio frequency (RF) receiver system for providing magnetic resonance (MR) information from an examination space of a MR imaging system, wherein the performance is improved by lowering the average power consumption and overall noise leading to an improved imaging performance.

According to the invention, this object is addressed by the subject matter of the independent claims. Preferred embodiments of the invention are described in the sub claims.

Therefore, according to the invention, a radio frequency (RF) receiver system for providing magnetic resonance (MR) information from an examination space of a MR imaging system is provided, comprising at least one RF coil with at least one connection port for receiving an analog MR information signal, and at least one analog to digital converter (ADC), which is connected to the at least one connection port and which converts the analog MR information signal into a digital MR information signal, whereby the at least one ADC is a RF band-pass sigma-delta analog to digital converter (ADC), the RF band-pass sigma-delta ADC comprising a summator, a loop band-pass filter, a quantizer unit, and a feedback digital to analog converter (DAC) unit, the quantizer unit and the feedback DAC unit are provided as N bit converter units with N being an integer greater than 1, wherein the feedback DAC unit is a non-uniform feedback DAC unit, wherein the quantizer unit is a non-uniform quantizer unit, the feedback DAC unit being arranged to produce analog levels in response to the levels produced by the non-uniform quantizer unit, the ADC being arranged to produce non-uniform levels by the non-uniform quantizer unit and the feedback DAC unit in proportion to the applied ADC input signal.

The solution described in this invention utilizes a RF band-pass sigma-delta ADC with a non-uniform quantizer unit in the loop. The band-pass sigma delta ADC is already an efficient solution for MR signal acquisition by exploiting the narrow-band nature of the signal. Using non-uniform quantization further improves the performance by lowering the average power consumption and overall noise.

Furthermore, due to the nature of the sigma-delta operation, the detection of the signal level is fully automatic and does not require additional control circuitry. For example, for small signal levels only one of the quantizer threshold levels is crossed and part of the quantizer unit and part of the feedback part are not activated at all. With the increase of the signal levels the full quantizer circuit starts to operate. The time instances on which it is activated are determined by the instantaneous signal levels. In order to adapt the operation of the multi-bit quantizer unit to the actual statistics of the amplitude of the MR signal, a quantizer unit with non-uniform quantization levels and a feedback DAC unit with corresponding non-uniform analog signal levels are introduced. This results in an optimal energy usage that corresponds to the instantaneous temporal behavior of the acquired MR signal.

In another aspect of the invention, the object is achieved by a magnetic resonance (MR) imaging system, comprising a main magnet for generating a static magnetic field, a magnetic gradient coil system for generating gradient magnetic fields superimposed to the static magnetic field, an examination space provided to position a subject of interest within, at least one radio frequency receiver system as described above for providing magnetic resonance information from the examination space, and a digital signal processing unit for processing of a digital MR information signal provided by the at least one RF receiver system.

In another aspect of the invention, the object is achieved by a method for providing magnetic resonance (MR) information from an examination space of a magnetic resonance (MR) imaging system, comprising:
- providing a radio frequency (RF) receiver system with at least one RF coil having at least one connection port, the radio frequency (RF) receiver system comprising a RF band-pass sigma-delta analog to digital converter, the RF band-pass sigma-delta analog to digital converter comprising a summator, a loop band-pass filter, a quantizer unit, and a digital to analog converter unit, wherein the quantizer unit and the digital to analog converter unit (DAC) are provided as N bit converter units with N being an integer greater than 1, wherein the quantizer unit is a non-uniform quantizer unit, wherein the feedback DAC unit is a non-uniform feedback DAC unit,
- receiving an analog MR information signal at the at least one connection port of the at least one RF coil within the RF receiver system,
- producing non-uniform quantization levels by the quantizer and the feedback DAC in proportion to the applied ADC input signal,
- performing an analog to digital conversion of the analog MR information signal into a digital MR information signal in the RF receiver system, whereby the step of performing an analog to digital conversion comprises performing a RF band-pass sigma-delta analog to digital conversion by the RF band-pass sigma-delta analog to digital converter,
- transmitting the digital MR information signal from the RF receiver system via a communication link.

In another aspect of the invention, the object is achieved by a software package for a magnetic resonance (MR) imaging system, whereby the software package contains instructions for controlling a radio frequency (RF) receiver system according to the method described above.

In a still further aspect of the invention, the object is achieved by a software package for upgrading a magnetic resonance (MR) imaging system, whereby the software package contains instructions for controlling a radio frequency (RF) receiver system according to the method described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 shows an image illustrating this signal behavior showing the amplitude statistics in time,
Fig. 2 depicts a radio frequency receiver system in accordance with the invention,
Fig. 3 is a detailed schematic illustration of electronic components of the RF receiver system of Fig. 2 including a RF band-pass sigma-delta analog to digital converter in accordance with the invention,
Fig. 4 shows the quantization error for a 4-level quantizer for a typical MR signal according to an embodiment of the invention,
Fig. 5 shows a flowchart of a method for providing magnetic resonance information from an examination space of a magnetic resonance imaging system in accordance with an embodiment of the invention.

### DETAILED DESCRIPTION OF EMBODIMENTS

Fig. 1 depicts an example illustrating the signal behavior showing the amplitude statistics in time, as already described above.

Fig. 2 depicts a radio frequency (RF) receiver system 1 in accordance with the invention. The RF receiver system comprises at least one RF coil 2 with at least one connection port 3 for receiving an analog MR information signal. The RF receiver system 1 further comprises a low noise amplifier (LNA) 4 for amplifying the analog MR information signal. The amplified MR information signal is propagated to an analog to digital converter (ADC) 6. The ADC 6 in this embodiment is a RF band-pass sigma-delta analog to digital converter.

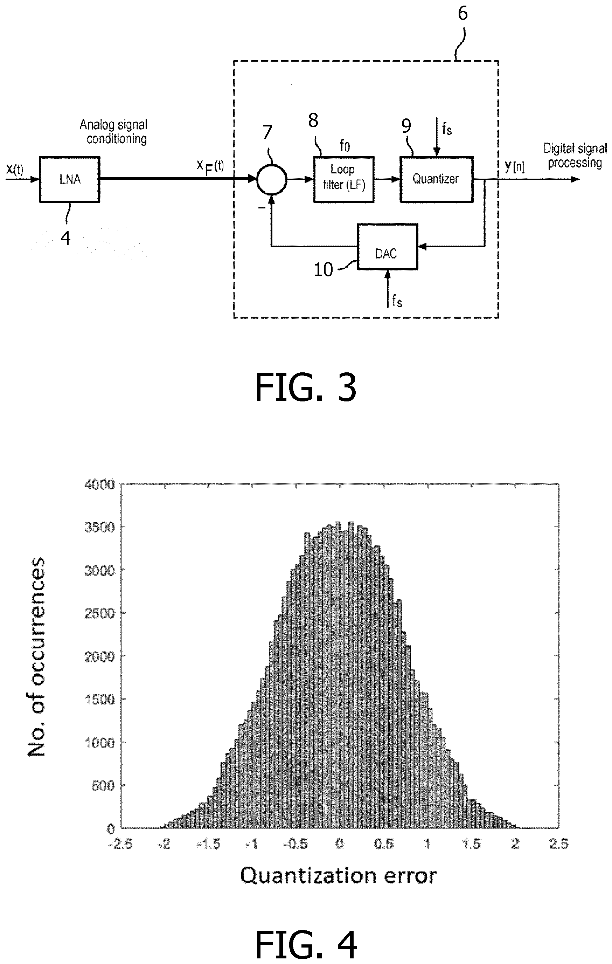

The RF band-pass sigma-delta ADC 6 comprises a summator 7, a loop band-pass filter 8, a quantizer unit 9, and a digital to analog converter unit 10, which are arranged in a feedback configuration, as can be seen in Fig. 3. The quantizer unit 9 and the digital to analog converter unit 10 are provided as N bit converter units with N being an integer greater than 1, in this embodiment.

Therefore, Fig. 3 shows a detailed schematic illustration of electronic components of the RF receiver system 1 of Fig. 1, including a RF band-pass sigma-delta ADC 6 in accordance with an embodiment of the invention, wherein the feedback DAC unit 10 is a non-uniform feedback DAC unit and the quantizer unit 9 is a non-uniform quantizer unit. A significant portion of the total power consumption can be attributed to the feedback DAC 10. The feedback DAC10 produces analog levels in response to the levels produced by the quantizer unit 9. In fact, the maximum levels produced by the DAC should match or exceed the maximum input signal that the ADC is expected to handle. The quantizer unit 9 controls the polarity of the feedback such that the DAC can track (when averaged) the polarity of the input signal.

In a 1-bit ADC 6, the quantizer unit 9 produces only 2 levels. Consequently, the feedback DAC unit 10 produces 2 levels, typically one magnitude with + ot - sign. Even if the input to the ADC 6 is very small for the majority of the acquisition period (as in the case of MRI), the quantizer unit 9 and hence the feedback DAC unit 10 will continue to produce 2 levels. This means the feedback DAC unit 10 has a constant power consumption regardless of the ADC input signal level. This is obviously inefficient for signals with a high dynamic range. The situation can be improved upon by using a multi-bit RF band-pass sigma-delta ADC 6 with a feedback DAC unit 10 and a quantizer unit 9. The impact of the multi-bit quantizer unit on the power consumption is that the level is broken into pieces such that when the signal is small only small feedback is available and when the signal grows the feedback also grows. This will result in uniform levels which are produced by the quantizer unit 9 and the feedback DAC unit 10 in proportion to the applied ADC input signal. Since, the amplitude and frequency characteristics of the MRI signal are known, the above solution can be further improved by making the quantizer unit 9 and hence the feedback DAC unit 10 produce non-uniform levels by using a non-uniform feedback DAC unit 10 and a non-uniform quantizer unit 9. The non-uniform levels of the feedback DAC unit 10 result in a non-uniform power consumption and noise. The low signals levels are closely spaced while the larger signals levels are increasingly spaced. This results in the feedback DAC unit 10 producing very small levels for a majority of the acquisition period. For a very small duration, the MRI signal becomes very large. The feedback DAC unit 10 then produces larger levels at the cost of higher power consumption and noise.

Fig. 4 shows the quantization error for a 4-level quantizer for a typical MR signal according to an embodiment of the invention. The non-uniform quantizer unit 9 is designed by carefully selecting its output levels and thresholds between adjacent levels.

The function of the quantizer unit 9 is tailored to a priori known signal statistics. When the statistics are fixed (e.g. classic MR imaging) the quantizer topology is also fixed and the operation is fully automatic. In the cases when the signal statistics are different in different acquisitions, e.g. when spectroscopy is done, a different dedicated mode can be programmed or autonomous tracking/adapting to the signal can be introduced.

In Fig. 4 the quantization error for a 4-level quantizer for a typical MR signal is shown. The thresholds and the steps are spaced such that the quantization error resembles a Gaussian distribution with zero mean. The result is that most of the quantization error is distributed around zero resulting in the best quantization noise performance. Using the above principle, different variations can be implemented. Some examples include: More levels around zero rather than at higher amplitudes will emphasize power savings over performance. A larger number of levels overall will increase flexibility and enable an optimum power consumption, performance trade-off.

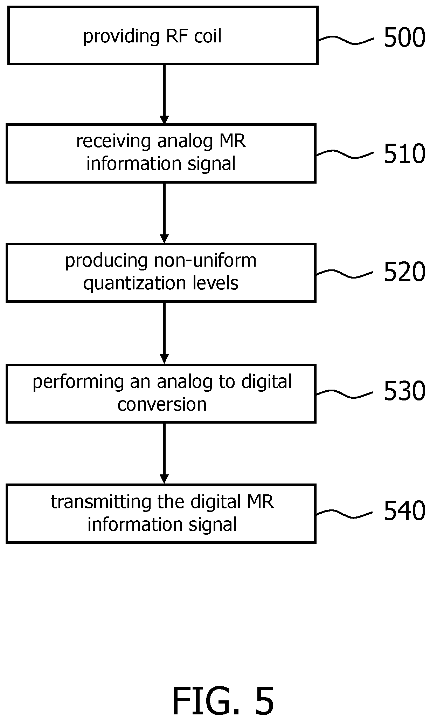

Fig. 5 shows a flowchart of a method for providing magnetic resonance information from an examination space of a magnetic resonance imaging system in accordance with an embodiment of the invention. The method starts with step 500, in which a radio frequency (RF) receiver system 1 with at least one RF coil 2 having at least one connection port 3 is provided, the radio frequency (RF) receiver system 1 comprising a RF band-pass sigma-delta analog to digital converter 6, the RF band-pass sigma-delta analog to digital converter 6 comprising a summator 7, a loop band-pass filter 8, a quantizer unit 9, and a digital to analog converter unit 10, wherein the quantizer unit 9 and the digital to analog converter unit (DAC) 10 are provided as N bit converter units with N being an integer greater than 1, wherein the quantizer unit 9 is a non-uniform quantizer unit, wherein the feedback DAC unit (10) is a non-uniform feedback DAC unit.

In step 510 an analog MR information signal is received at the at least one connection port 3 of the at least one RF coil 2 within the RF receiver system 1.

In step 520, non-uniform quantization levels are produced by the quantizer 9 and the feedback DAC 10 in proportion to the applied ADC input signal.

In step 530, an analog to digital conversion of the analog MR information signal into a digital MR information signal in the RF receiver system 1 is performed, whereby the step of performing an analog to digital conversion comprises performing a RF band-pass sigma-delta analog to digital conversion by the RF band-pass sigma-delta analog to digital converter 6.

In step 540 the digital MR information signal is transmitted from the RF receiver system 1 via a communication link.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| Radio frequency (RF) receiver system | 1 |
| RF coil | 2 |
| connection port | 3 |
| low-noise amplifier | 4 |
| analog to digital converter (ADC) | 6 |
| summator | 7 |
| loop band-pass filter | 8 |
| quantizer unit | 9 |
| digital to analog converter (DAC) | 10 |

## Claims

1. Radio frequency (RF) receiver system (1) for providing magnetic resonance (MR) information from an examination space of a MR imaging system, comprising
at least one RF coil (2) with at least one connection port (3) for receiving an analog MR information signal,
and at least one analog to digital converter (ADC) (6), which is connected to the at least one connection port (3) and which converts the analog MR information signal into a digital MR information signal, whereby
the at least one ADC (6) is a RF band-pass sigma-delta analog to digital converter (ADC),
the RF band-pass sigma-delta ADC (6) comprising a summator (7), a loop band-pass filter (8), a quantizer unit (9), and a feedback digital to analog converter (DAC) unit (10),
the quantizer unit (9) and the feedback DAC unit (10) are provided as N bit converter units with N being an integer greater than 1,
wherein the feedback DAC unit (10) is a non-uniform feedback DAC unit,
wherein the quantizer unit (9) is a non-uniform quantizer unit,
the non-uniform feedback DAC unit (10) being arranged to produce analog levels in response to the levels produced by the non-uniform quantizer unit (9),
the ADC (6) being arranged to produce non-uniform quantization levels by the non-uniform quantizer unit (9) and the feedback DAC unit (10) in proportion to the applied ADC input signal.

2. A magnetic resonance (MR) imaging system, comprising
a main magnet for generating a static magnetic field,
a magnetic gradient coil system for generating gradient magnetic fields superimposed to the static magnetic field,
an examination space provided to position a subject of interest within,
at least one radio frequency receiver system (1) as claimed in claim 1 for providing magnetic resonance information from the examination space, and
a digital signal processing unit for processing of a digital MR information signal provided by the at least one RF receiver system.

3. A method for providing magnetic resonance (MR) information from an examination space of a magnetic resonance (MR) imaging system, comprising:
- providing a radio frequency (RF) receiver system (1) with at least one RF coil (2) having at least one connection port (3), the radio frequency (RF) receiver system (1) comprising a RF band-pass sigma-delta analog to digital converter (6), the RF band-pass sigma-delta analog to digital converter (6) comprising a summator (7), a loop band-pass filter (8), a quantizer unit (9), and a digital to analog converter unit (10), wherein the quantizer unit (9) and the digital to analog converter unit (DAC) (10) are provided as N bit converter units with N being an integer greater than 1, wherein the quantizer unit (9) is a non-uniform quantizer unit, wherein the feedback DAC unit (10) is a non-uniform feedback DAC unit,
- receiving an analog MR information signal at the at least one connection port (3) of the at least one RF coil (2) within the RF receiver system (1),
- producing non-uniform quantization levels by the quantizer (9) and the feedback DAC (10) in proportion to the applied ADC input signal,
- performing an analog to digital conversion of the analog MR information signal into a digital MR information signal in the RF receiver system (1), whereby the step of performing an analog to digital conversion comprises performing a RF band-pass sigma-delta analog to digital conversion by the RF band-pass sigma-delta analog to digital converter (6),
- transmitting the digital MR information signal from the RF receiver system (1) via a communication link.

4. A software package for a magnetic resonance (MR) imaging system, whereby the software package contains instructions for controlling a radio frequency (RF) receiver system (1) according to the method claim 3.

5. A software package for upgrading a magnetic resonance (MR) imaging system, whereby the software package contains instructions for controlling a radio frequency (RF) receiver system (1) according to the method claim 3.
